# FASCICULE DE BREVET EUROPEEN

(11) **EP 3 249 468 B1**
(45) Date de publication et mention de la délivrance du brevet: **26.12.2018**
(21) Numéro de dépôt: 17172346.3
(22) Date de dépôt: 23.05.2017
(51) Int. Cl.: G03F 7/00, G03F 7/20

(54) **PROCÉDÉ DE RÉALISATION DE MOTIFS**
VERFAHREN ZUR HERSTELLUNG VON MOTIVEN
METHOD FOR PRODUCING PATTERNS

(30) Priorité: 27.05.2016 FR 1654822
(43) Date de publication de la demande: 29.11.2017
(73) Titulaire: Commissariat à l'Energie Atomique et aux Energies Alternatives, 75015 Paris (FR)
(72) Inventeur: POSSEME, Nicolas, 38360 SASSENAGE (FR); LANDIS, Stefan, 38210 TULLINS (FR); NOURI, Lamia, 38100 GRENOBLE (FR)
(74) Mandataire: Hautier, Nicolas

(56) Documents cités:
- WO-A1-2014/102222
- FR-A1- 3 028 350
- US-B1- 6 207 517

## Description

### DOMAINE TECHNIQUE DE L'INVENTION

L'invention concerne en général la réalisation de structures dans le domaine des procédés utilisés par l'industrie de la microélectronique pour la fabrication de toutes sortes de systèmes, de taille micrométrique et nanométrique, combinant possiblement des composants électroniques, optiques et mécaniques.

Plus précisément, elle concerne les procédés dans lesquels il est nécessaire d'aligner des motifs par rapport à d'autres motifs préalablement réalisés.

L'invention trouve pour application particulièrement avantageuse la réalisation de microlentilles asphériques destinées à des applications de collection de lumière, d'imagerie et de guidage de la lumière. Elle trouve également comme application avantageuse la réalisation de structures dites « double damascène » pour l'interconnexion verticale de lignes métalliques notamment en cuivre.

### ÉTAT DE LA TECHNIQUE

Pour de nombreuses applications, il est nécessaire de réaliser des motifs alignés sur d'autres motifs préalablement définis lors d'opérations de photolithographie et de gravure précédentes.

La réduction constante des dimensions des motifs pose alors la difficulté de parvenir à effectivement aligner les motifs avec suffisamment de précision lors d'opérations successives de photolithographie.

Ce problème est particulièrement important pour la réalisation de matrices de microlentilles utilisées dans de nombreux dispositifs optoélectroniques. Dans ce domaine il existe déjà de nombreux procédés de fabrication. Une revue de techniques connues de fabrication de microlentilles pourra par exemple être trouvée dans la publication suivante en langue anglaise : « Journal of Optics A: Pure and Applied Optics 8, issue 7 » pages 407-429, publiée en 2006.

Parmi celles-ci, l'impression microjet ou « microjet printing » et le fluage thermique ou « thermal reflow » sont désormais des techniques très avancées qui sont utilisées dans l'industrie pour réaliser des microlentilles de haute qualité optique. Cependant, ces techniques sont plus qualitatives que quantitatives lorsqu'il s'agit d'atteindre un profil de surface prédéterminé destiné à conférer aux lentilles les propriétés optiques attendues. Par exemple, le fluage thermique de photo-résine et l'impression microjet sont basés sur les tensions de surfaces ce qui limite fortement le choix des profils de surface que l'on peut obtenir en pratique avec ces techniques.

D'autres techniques connues telles que l'ablation laser, la polymérisation à deux photons et l'écriture directe au laser permettent d'obtenir un très grand choix de profils de surfaces, mais sont des techniques séquentielles qui demandent que chaque lentille d'une matrice soit individuellement façonnée. Il en résulte que ces techniques ne sont pas applicables en termes de coûts et de rendement à une échelle industrielle.

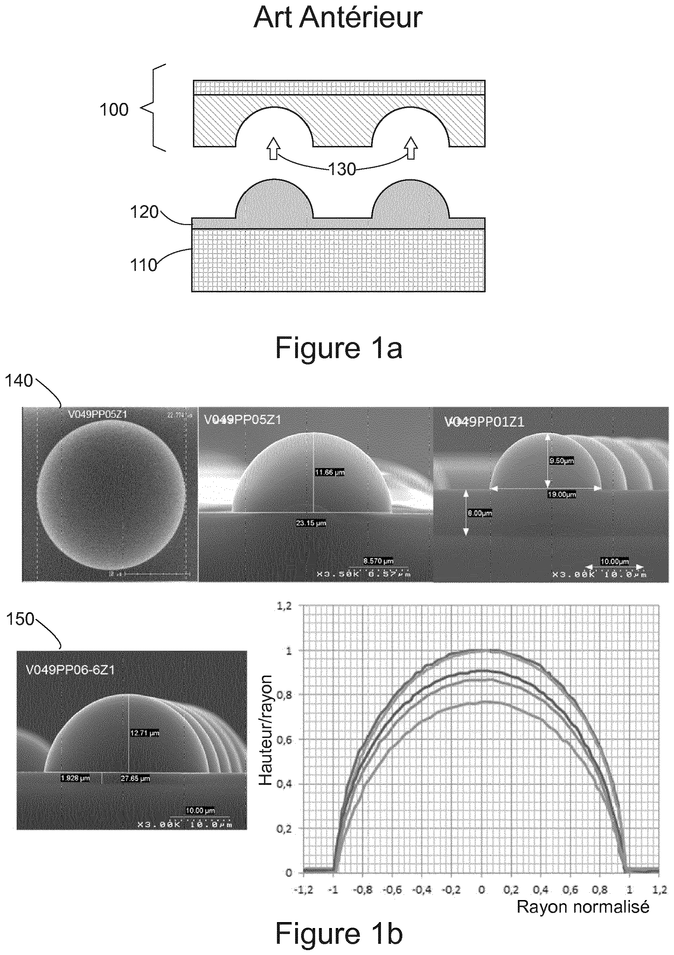

Plus récemment, les techniques de moulage et d'impression telles que celles généralement désignées par leurs appellations anglaises de « hot embossing », « imprinting » et « injection moulding » ont beaucoup été utilisées pour réaliser des microlentilles. Le principe de fabrication, illustré par la **figure 1****,** composée des figures 1a et 1b, est de remplir un moule 100 d'un matériau malléable, typiquement un polymère, et ensuite de détacher 130 celui-ci du matériau moulé 120. La figure 1b montre que les microlentilles obtenues de cette façon peuvent être de formes hémisphérique 140 et asphérique 150. Selon le type de substrat 110 sur lequel le moulage est fait, en silicium selon un mode de réalisation ou en quartz ou verre selon un autre mode de réalisation, les applications pourront concerner, respectivement, le domaine des longueurs d'ondes de l'infra-rouge (IR) ou celui de la lumière visible.

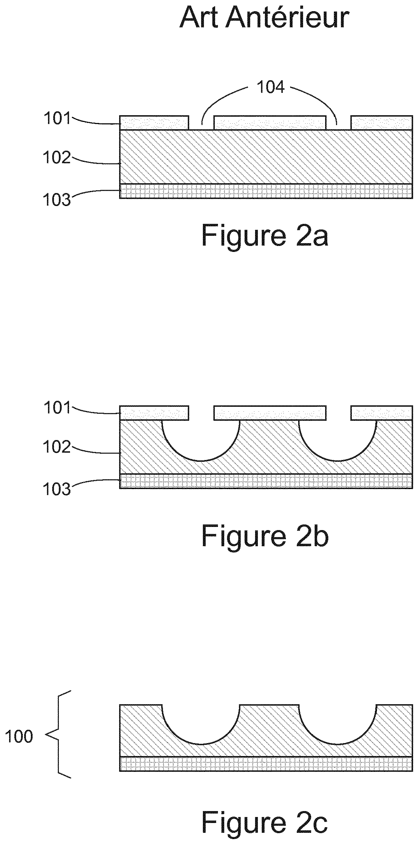

Les méthodes de fabrication par impression nécessitent de disposer de moules qui peuvent être eux-mêmes fabriqués par exemple à l'aide des techniques citées dans la publication mentionnée ci-dessus (« Journal of Optics »). En règle générale, les techniques standards mises en oeuvre par l'industrie de la microélectronique sont le plus souvent préférées car elles sont très fiables et l'intégration des microlentilles aux composants finaux, typiquement des composants électronique de type transistor, en est facilitée. La **figure 2****,** composée des figures 2a à 2c, illustre un exemple de fabrication de moule. Comme montré sur la figure 2a, après dépôt d'une couche 102 d'un oxyde thermique de silicium (SiO2) ou silice, par exemple d'une épaisseur de 20 micromètres (µm), sur un « wafer » du type de ceux utilisés couramment par l'industrie de la microélectronique, c'est-à-dire une tranche 103 de silicium de grand diamètre, par exemple d'un diamètre de 8 pouces, une couche 101 de nitrure de silicium (Si3N4), par exemple d'une épaisseur de 350 nanomètres, est déposée sur la couche d'oxyde thermique. Les motifs 104 destinés à former les reliefs du moule sont d'abord gravés dans la couche de nitrure 101 à l'aide d'étapes conventionnelles de lithographie (figure 2a). Le wafer est alors immergé dans une solution de gravure humide, par exemple une solution à base d'acide fluorhydrique (HF). Comme montré sur la figure 2b, le masque de nitrure protège les zones du wafer où la solution de gravure ne doit pas attaquer la couche de silice 102. La gravure de la couche de silice 102 est isotrope, formant ainsi une cavité, en forme de portion de sphère, centrée sur les motifs 104. A l'étape suivante illustrée en figure 2c, le masque de nitrure est retiré et après application d'un traitement antiadhésif, le wafer peut être utilisé comme moule 100 pour l'impression.

Optionnellement, les motifs en relief du moule peuvent être créés directement dans le silicium 103 sans avoir recours à la couche intermédiaire de silice 102. Dans ce cas, la solution de gravure est un mélange d'acide fluorhydrique (HF) et d'acide nitrique (HNO3) comme rapporté en 2009 dans un article paru dans la revue en langue anglaise Optics Express, Volume 17, Edition 8, pages 6283 à 6292 (2009).

Si les procédés de fabrication de moule brièvement décrits ci-dessus conviennent bien pour l'obtention, comme représenté de motifs sphériques ou hémisphériques, il est en revanche difficile d'obtenir des lentilles dites asphériques de formes voulues avec ces procédés. Or, la production de matrices de micro lentilles asphériques est généralement requise dans beaucoup d'applications. Ces lentilles asphériques présentent en effet habituellement des propriétés optiques bien meilleures. Notamment, les lentilles sphériques, contrairement aux lentilles asphériques, induisent des aberrations optiques, les rayons passant par le centre de la lentille ne convergeant pas exactement au même point que ceux passant par les bords. Ceci provoque un flou aux grandes ouvertures et un élargissement de la tache de focalisation qu'il n'est pas possible d'ignorer dans la plupart des applications.

Il faut alors avoir recours à l'utilisation de lasers et aux techniques dites de « laser machining » ou ablation laser, déjà mentionnées ci-dessus, qui seules sont susceptibles de pouvoir créer les profils complexes nécessaires avec toutefois l'inconvénient majeur que chaque micro lentille doit alors être façonnée individuellement. Ces techniques sont par exemple décrites dans l'article Spherical and Aspheric Microlenses Fabricated by Excimer Laser LIGA-like Process Yung-Chun Lee, Chun-Ming Chen and Chun-Ying Wu paru en 2006 dans la revue en langue anglaise « Journal of Manufacturing Science and Engineering » 129, 126-134.

De manière générale, il n'existe pas de procédé simple, rapide, c'est-à-dire opérable en une seule série d'étapes à l'échelle d'un wafer, également compatible avec les techniques standards de la microélectronique et qui permette de contrôler simplement le profil de surface en vue de produire notamment des matrices de lentilles asphériques.

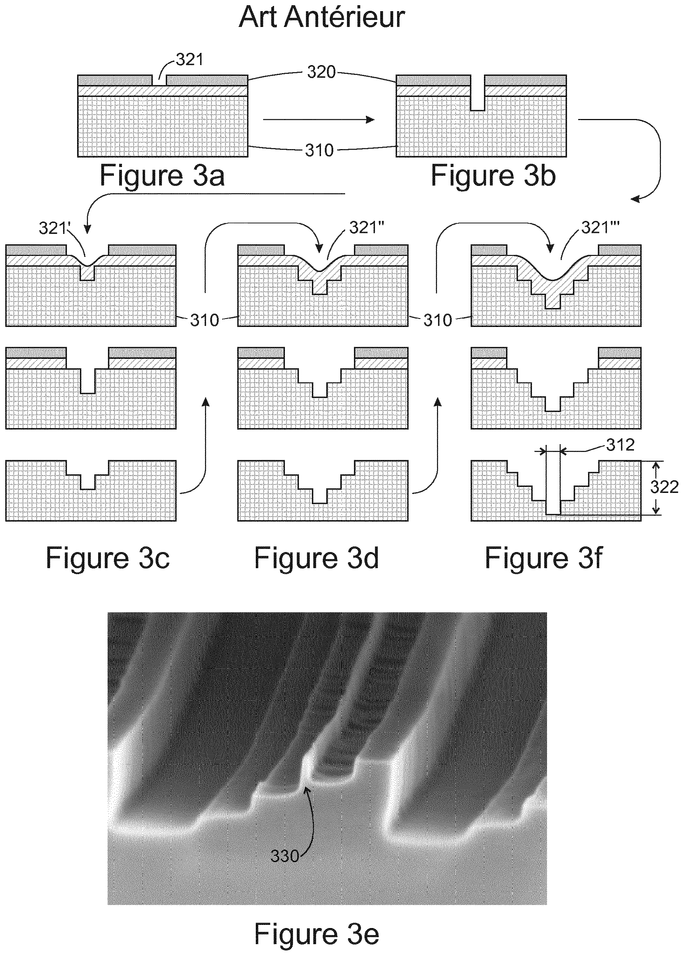

Une autre façon d'aborder le problème de la création de profils complexes, comme ceux nécessaires à la production des lentilles asphériques et aussi pour des applications autres que l'optique, consiste à pouvoir réaliser des structures tridimensionnelles (3D) en marches d'escalier c'est-à-dire présentant plusieurs niveaux discrets de hauteurs comme illustré sur la **figure 3****,** composée des figures 3a à 3e. Dans le cas de la production de matrices de microlentilles on va alors pouvoir approximer les profils souhaités à l'aide d'un plus ou moins grand nombre de marches.

Le procédé standard qui permet la réalisation de ces structures 3D en marches d'escalier est compliqué et nécessite un nombre conséquent d'étapes comme cela est illustré sur la figure 3. Il faut pouvoir répéter en fonction du nombre de marches à réaliser, au nombre de quatre dans l'exemple de la figure 3, une série d'étapes de lithographie et gravure, représentées par les figures 3a à 3f, qui peuvent être difficiles à mettre en oeuvre pour des dimensions critiques 312 de motifs à réaliser, typiquement inférieures au µm, et pour des rapports de formes élevés 322, typiquement supérieurs à 3.

Une difficulté particulière consiste à pouvoir aligner précisément les étapes successives de structuration les unes par rapport aux autres. En particulier, après chaque gravure du substrat 310, il faut redéposer une couche de résine 320 et reformer un motif aligné sur le motif précédent. Ainsi, les motifs 321', 321", 321'" doivent tous être alignés sur le motif 321.

A défaut de pouvoir aligner très précisément les opérations de photolithographies correspondantes entre elles, on peut obtenir des artefacts de gravure 330 comme celui apparaissant sur la figure 3e qui est une photographie réalisée à partir d'un équipement de microscopie électronique à balayage sur une structure 3D à quatre niveaux similaire à celles des figures précédentes. La présence de tels défauts est évidemment très dommageable et ne permet plus d'obtenir le profil final souhaité.

Un objet de la présente invention est donc de proposer un procédé s'appliquant au niveau d'un wafer pour la production de profils et qui permette de s'affranchir ou au moins de limiter certains au moins des problèmes exposés ci-dessus.

Notamment, la présente invention a pour objectif de proposer une solution simple et fiable pour obtenir un profil à partir d'opérations de lithographies qui nécessitent d'être auto-alignées et ceci tout en offrant un bon contrôle dimensionnel.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un aspect de la présente invention concerne un procédé de réalisation de motifs dans une couche à graver, à partir d'un empilement comprenant au moins la couche à graver et une couche de masquage surmontant la couche à graver, la couche de masquage présentant au moins un motif, le procédé comprenant au moins:
a) une étape de modification d'au moins une première zone de la couche à graver par implantation d'ions à travers la couche de masquage;
b) au moins les étapes suivantes:
   b1) une étape de dépôt d'au moins une couche tampon de manière à recouvrir au moins le motif de ladite couche de masquage ;
   b2) une étape de modification d'au moins une autre zone de la couche à graver, différente de la première zone, par implantation d'ions à travers ladite couche tampon, l'implantation étant effectuée jusqu'à une profondeur de la couche à graver supérieure à la profondeur d'implantation de l'étape précédente de modification ;
c) au moins une étape de retrait de ladite au moins une couche tampon ;
d) une étape de retrait de la couche de masquage ;
e) une étape de retrait des zones modifiées, le retrait comprenant une étape de gravure des zones modifiées sélectivement aux zones non modifiées de la couche à graver.

De manière avantageuse mais optionnelle uniquement, l'étape de dépôt de la couche tampon est un dépôt conforme.

On entend par « conforme », une géométrie de couches qui présente, aux tolérances de fabrication près, une épaisseur constante malgré les changements de direction des couches, par exemple au niveau de flancs verticaux de certaines structures.

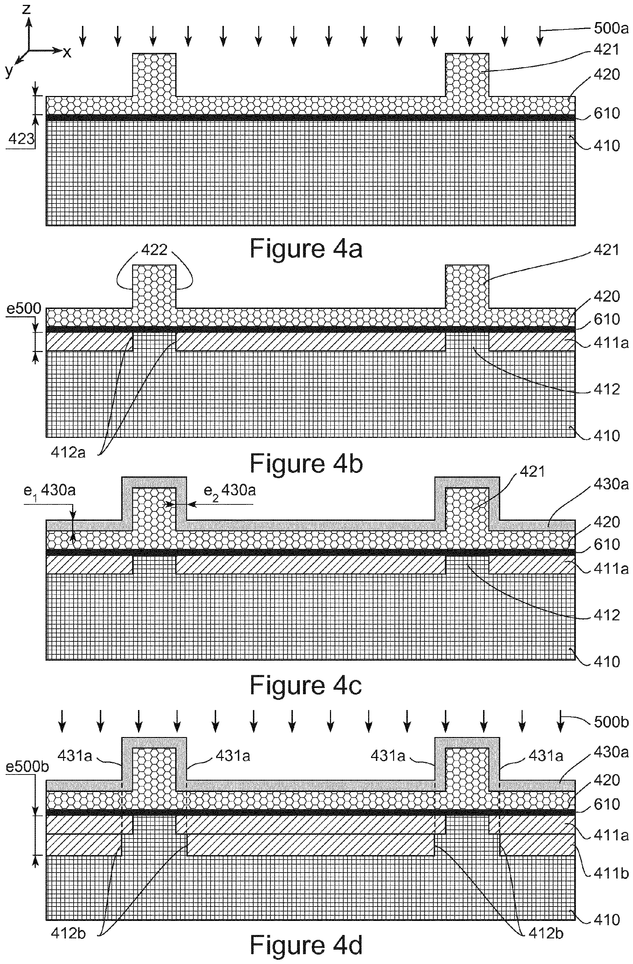

Ainsi, l'invention permet, grâce notamment à l'étape de dépôt de la couche tampon recouvrant le motif et à l'implantation à travers la couche tampon, de définir plusieurs zones modifiées qui sont automatiquement alignées les unes par rapport aux autres. L'alignement considéré est selon un plan parallèle au plan principal contenant la couche à graver. Sur les figures qui suivent cet alignement est suivant le plan horizontal (XY sur le repère de la figure 4a).

Les motifs successifs dont les flancs externes sont formés par la ou les couches tampons déposées successivement, sont tous formés sur le motif initial défini par la couche de masquage. Ainsi tous les motifs servant aux implantations successives sont donc auto-alignés.

L'invention permet ainsi d'obtenir une structure dont le profil est exempt des défauts d'alignement habituellement rencontrés avec les procédés connus nécessitant des opérations successives de lithographies.

Par ailleurs, par rapport à une solution dans laquelle on implanterait la couche à graver au droit d'un motif en creux réalisé dans la couche de masquage, puis dans laquelle on élargirait par trimming le motif avant une nouvelle implantation sur une profondeur plus faible, l'invention présente pour avantage de ne pas consommer d'épaisseur de couche de masquage entre deux implantations. Par conséquent, la profondeur des implantations est maîtrisée avec une grande précision.

L'invention offre ainsi une solution simple et fiable pour obtenir un profil possiblement complexe et présentant une définition améliorée, optionnellement en répétant plusieurs fois ladite séquence d'étapes b1) et b2) avant les étapes d) et e) de retrait de la couche de masquage et de retrait des zones modifiées.

Un autre objet de la présente invention concerne un procédé de réalisation de moule pour former par nano-impression des lentilles asphériques. Le procédé comprend les étapes a) à e) ci-dessus et la séquence comprenant au moins les étapes b1) et b2), éventuellement l'étape c), est répétée de manière à obtenir un profil en creux, asphérique, formé de marche d'escaliers.

Un autre objet de la présente invention concerne un dispositif microélectronique réalisé en mettant en oeuvre l'un des procédés selon l'invention. Par dispositif microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...)

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1, composée des figures 1a et 1b, illustre le principe de fabrication par moulage de lentilles hémisphériques ou formées par une portion de sphère.
La FIGURE 2, composée des figures 2a à 2c, illustre un exemple de fabrication de moule d'impression portant une empreinte qui forme une portion de sphère.
La FIGURE 3, composée des figures 3a à 3e, illustre une méthode conventionnelle de réalisation d'une structure tridimensionnelle (3D) en marches d'escalier.
La FIGURE 4, composée des figures 4a à 4h, décrit les étapes d'un exemple de procédé selon l'invention qui permet par exemple de réaliser des structures 3D en marches d'escalier auto alignées.
La FIGURE 5 compare l'utilisation d'un implanteur classique et celle d'un réacteur de gravure pour les opérations d'implantation d'ions mises en oeuvre dans le cadre de l'invention.
La FIGURE 6, illustre des étapes d'un premier exemple de procédé selon l'invention.
La FIGURE 7, illustre des étapes d'un deuxième exemple de procédé selon l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et films ne sont pas représentatives de la réalité.

### DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement.

Selon un mode de réalisation, avant l'étape c) de retrait de ladite au moins une couche tampon, on effectue plusieurs fois, de préférence au moins deux fois et de préférence au moins trois fois, une séquence d'étapes, chaque séquence comprenant les étapes b1) et b2), une couche tampon déposée lors d'une séquence donnée s'empilant ainsi sur une couche tampon déposée lors d'une séquence précédent la séquence donnée.

Ainsi les couches tampons déposées s'empilent les unes sur les autres au fur et à mesure des séquences.

Selon un mode de réalisation une couche tampon déposée lors d'une séquence donnée présente une épaisseur identique à l'épaisseur d'une couche tampon déposée lors d'une séquence précédent la séquence donnée. Cela évite d'avoir à régler l'épaisseur à déposer pour chaque couche tampon, ce qui facilite le procédé et améliore sa fiabilité.

Par ailleurs ce mode de réalisation permet d'effectuer une seule étape de retrait pour retirer toutes les couches tampon déposées successivement.

Selon un mode de réalisation alternatif, avant l'étape d) de retrait de la couche de masquage, on effectue plusieurs fois, de préférence au moins deux fois et de préférence au moins trois fois, une séquence d'étapes, chaque séquence comprenant les étapes b1), b2) et c).

De préférence une couche tampon déposée lors d'une séquence donnée présente une épaisseur supérieure à l'épaisseur d'une couche tampon déposée lors d'une séquence précédent la séquence donnée.

Ainsi, après chaque étape d'implantation à travers une couche tampon on retire cette couche tampon.

Selon un mode de réalisation, ladite étape de gravure des zones modifiées sélectivement aux zones non modifiées de la couche à graver est une gravure humide.

En particulier la gravure humide offre un gain de temps tout en apportant un bon contrôle dimensionnel et un bon état de surface. Le procédé selon l'invention s'avère ainsi rapide et parfaitement conforme aux contraintes industrielles en termes de productivité.

Selon un mode de réalisation, le motif est un motif en relief. L'étape d'implantation est effectuée de manière à ce que la zone de la couche à graver située au droit du motif soit non implantée ou soit implantée sur une profondeur plus faible que les zones non situées au droit du motif.

Alternativement le motif est un motif en creux. L'étape d'implantation est effectuée de manière à ce que la zone de la couche à graver située au droit du motif soit implantée sur une profondeur plus importante que les zones non situées au droit du motif.

Selon un mode de réalisation, la couche de masquage portant le motif initial est conservée lors de l'étape de dépôt de la couche tampon et lors de l'implantation dans la couche à graver à travers la couche tampon.

Selon un mode de réalisation, l'empilement comprend une couche intercalaire disposée entre la couche de masquage et la couche à graver et recouvrant la couche à graver lors de l'implantation.

Selon un mode de réalisation, la couche de masquage comprend du carbone et l'épaisseur de la couche intercalaire est suffisante pour former une barrière empêchant, lors des implantations, à des espèces carbonées provenant de la couche de masquage de pénétrer à l'intérieur de la couche à graver.

Cela permet de transférer avec précision dans la couche à graver les motifs sans que des atomes de carbone provenant de la couche de masquage ne soient transférés dans la couche à graver et ne viennent perturber la gravure de cette dernière.

Selon un mode de réalisation, l'épaisseur de la couche intercalaire est réglée de manière à ce qu'au niveau des zones modifiées les ions soient implantés en continu depuis la surface de la couche à graver.

Avantageusement cela permet d'utiliser des implanteurs standards tout en ayant une modification de la couche à graver continue depuis sa surface.

Selon un mode de réalisation, la couche intercalaire est en un matériau pris parmi les matériaux suivants : SixOy, SiOx, SixNy, SiNx, TiN, SiARC.
Selon un mode de réalisation, la couche intercalaire est en résine.

Selon un mode de réalisation, l'implantation est effectuée avec un implanteur. De préférence, l'épaisseur de la couche intercalaire est réglée de manière à ce qu'au niveau des zones modifiées les ions soient implantés en continu depuis la surface de la couche à graver.

Selon un autre mode de réalisation avantageux, l'implantation est effectuée dans un réacteur plasma. Cela présente pour avantage de pouvoir implanter les ions en continu depuis la surface de la couche à graver.

Selon un mode de réalisation, les étapes de retrait de la ou des couche(s) tampon et l'étape de retrait de la couche de masquage sont effectuées au cours d'une même gravure. Alternativement elles sont effectuées au cours de deux gravures successives.

Selon un mode de réalisation, les étapes b1) et b2) sont choisies, en particulier l'épaisseur de la couche tampon et la profondeur d'implantation, de manière à ce que les zones modifiées forment un profil en marches d'escalier.

Selon un mode de réalisation, après gravure d'un profil en marches d'escalier dans la couche à graver on procède à un lissage dudit profil par oxydation et désoxydation du matériau de la couche à graver.

Selon un mode de réalisation, le profil présente le négatif d'une forme de lentille asphérique.

Selon un mode de réalisation, le profil forme un moule configuré pour pénétrer dans une résine imprimable afin d'y transférer par nano-impression le profil.

Selon un mode de réalisation, préalablement aux étapes a) à c), la couche de masquage comporte une pluralité de motifs et les étapes a) à c) sont appliquées à ladite pluralité de motifs.

Selon un mode de réalisation avantageux, la couche à graver est une couche ou un substrat dont le matériau est pris parmi : le silicium, le silicium germanium, le germanium, le nitrure de silicium, le saphir, le verre, le quartz ce dernier étant cristallin au contraire du verre.

Selon un autre mode de réalisation, la couche à graver est une couche ou un substrat en SiOCH. Le SiOCH peut être poreux ou dense. Ce matériau présente pour avantage d'avoir une très faible permittivité, en particulier lorsqu'il est poreux.

Selon un mode de réalisation, la couche à graver est une couche cristalline.

Selon un mode de réalisation la couche de masquage est une couche formant un masque dur.

Le masque dur est par exemple un masque dur inorganique, non carboné. Il peut alors être par exemple en SiOx ou en SiNx et plus particulièrement en SiO2 ou SiN. Il peut également être un masque dur métallique, par exemple en TiN.

Selon un mode de réalisation la couche de masquage est disposée directement au contact de la couche à graver.

Selon un mode de réalisation, le matériau du masque dur est pris parmi le SiOx, le SiNy, le SiARC et le TiN.

Avantageusement, on utilisera un masque dur pour réaliser des motifs de petites dimensions latérales nécessitant donc une faible ouverture totale dans le masque et donc une faible épaisseur de masque.

Alternativement, la couche de masquage est une couche de résine.

Selon un mode de réalisation, ladite au moins une couche tampon est à base de nitrure de silicium (SiN) ou à base d'oxyde de silicium (SiOₓ) tel que le dioxyde de silicium (SiO₂).

Sont énoncées ci-après d'autres caractéristiques optionnelles qui peuvent éventuellement être utilisées en association ou alternativement.

Selon un mode de réalisation, l'étape de gravure utilise une solution d'hydroxyde d'ammonium tétra-méthyle (TMAH) ou d'acide fluorhydrique (HF), de préférence sous atmosphère d'oxygène. Cette gravure permet une très bonne sélectivité des zones modifiées par implantation par rapport aux zones non modifiées. Ainsi, le silicium cristallin de la couche à graver n'est pas ou peu consommé par ce type de nettoyage alors que le silicium rendu amorphe par l'implantation est aisément consommé.

Selon un mode de réalisation, préalablement à ladite séquence d'étapes, on effectue une étape de réalisation dans la couche de masquage de l'au moins un motif.

Dans le cadre de la présente invention, on pourra utiliser les méthodes connues de l'homme du métier et les logiciels (SRIM, TRIM, CTRIM...) qui permettent de simuler en fonction des conditions d'implantation (espèces implantées, matériau implanté, dose, énergie, temps d'exposition de la couche implantée au faisceau d'ions...) l'implantation résultante et notamment la profondeur d'implantation.

Avantageusement, les paramètres d'implantation, en particulier l'énergie communiquée aux ions, la durée et la dose d'implantation, sont prévus de sorte que les zones implantées puissent être gravées sélectivement par rapport aux zones non-implantées. De préférence, ces paramètres d'implantation permettent de faire passer la matière depuis un état cristallin à un état amorphe.

De préférence, l'implantation d'espèces concerne tous les éléments que l'on peut implanter dans le matériau à graver, sans provoquer de dislocation de sa structure atomique telle qu'elle entraînerait une pulvérisation de la matière implantée, sont susceptibles de convenir.

Par exemple, les ions implantés sont pris parmi l'hydrogène (H2), l'hélium (He), l'argon (Ar) ou l'azote (N2). Une seule ou plusieurs de ces espèces peuvent être implantées.

Selon un mode de réalisation, l'implantation est réalisée de manière anisotrope, selon au moins une direction d'implantation sensiblement perpendiculaire au plan dans lequel s'étend la couche à graver ou un substrat sur lequel est disposée la couche à graver. Sur les figures, la direction privilégiée d'implantation est la direction Z.

Il est précisé que dans le cadre de la présente invention, le terme « sur », « surmonte », « recouvre » ou « sous-jacent » ou leurs équivalents ne signifient pas « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par au moins une autre couche ou au moins un autre élément.

Dans le cadre de la présente invention, l'épaisseur d'une couche est prise selon une direction perpendiculaire aux faces principales du substrat sur lequel repose les différentes couches. Sur les figures, l'épaisseur est prise selon la direction Z indiquée sur le repère illustré en figure 4a. Sur les figures, la largeur d'un motif est prise selon la direction X indiquée sur ce même repère.

De même lorsqu'on indique qu'une zone est située au droit d'un motif, cela signifie que ce motif et cette zone sont situés tous deux sur une même ligne perpendiculaire au plan principal du substrat, soit sur une même ligne orientée verticalement sur les figures (axe Z).

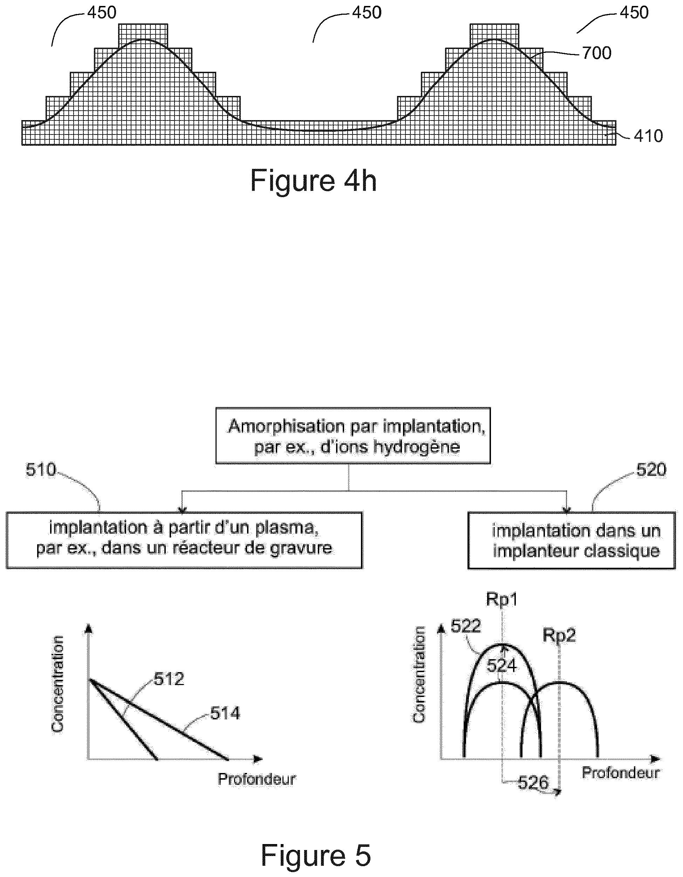

Dans le cadre de la présente invention, on désigne par motif en trois dimensions (3D) un motif présentant dans une couche donnée, par exemple une résine ou un substrat, un profil analogique avec une variation continue des tangentes de la forme du profil comme le profil 700 illustré en figure 4h par exemple ou présentant au moins deux niveaux de profondeur au-dessous de la face supérieure de la couche lorsque le motif est en creux ou au moins deux niveaux de hauteur au-dessus d'une face supérieure de la couche lorsque le motif est en saillie. Un motif dit 2D désigne le cas particulier d'un motif n'ayant que deux niveaux de hauteur ou de profondeur.

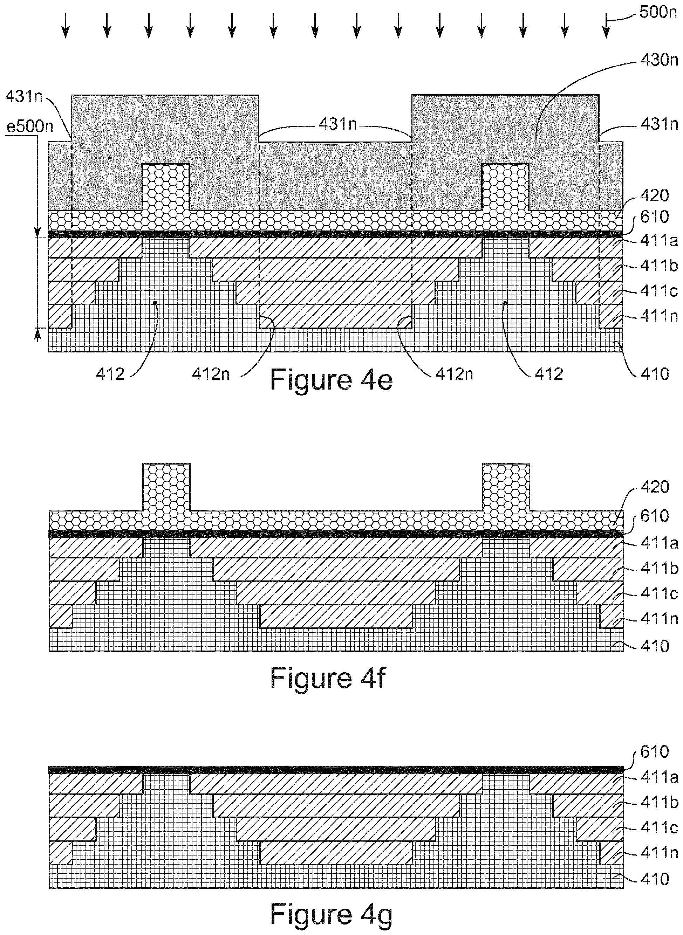

La **figure 4****,** composée des figures 4a à 4h, décrit les étapes du procédé de l'invention qui permet de s'affranchir des problèmes décrits précédemment dans l'état de la technique pour réaliser notamment mais non limitativement des structures 3D, par exemple des profils en marches d'escalier.

Le procédé de l'invention permet en effet de réaliser, au moyen d'une succession d'étapes de dépôt de couches tampon suivies chacune d'une implantation d'ions, des moules de formes courbes contrôlées afin d'obtenir notamment des microlentilles asphériques. De manière particulièrement avantageuse, cela se fait à partir d'une seule opération de photolithographie et de dépôts successifs de couches tampon suivis chacun d'une implantation sur une profondeur plus importante que l'implantation précédente.

Un contrôle précis des conditions d'implantation en fonction des épaisseurs des couches tampon permet alors d'obtenir les formes de lentille optimales pour une application donnée à l'aide d'un procédé peu coûteux. Un avantage majeur du procédé de l'invention est en effet qu'il permet de réaliser des structures auto-alignées à partir d'une seule étape initiale de photolithographie et donc à moindre coût par comparaison à la succession d'étapes de photolithographie indépendantes du procédé conventionnel où l'on doit réaligner les surfaces implantées les unes par rapport aux autres à chaque étape et avec les inconvénients discutés précédemment dans la description de la figure 3.

Comme illustré en figure 4a, on part de préférence d'un empilement comprenant au moins une couche à graver 410 et une couche de masquage 420 surmontant la couche à graver.

Dans la suite de la description, par souci de concision et de clarté, on désigne par « substrat 410 » cette couche à graver dans laquelle des motifs vont être formés. Ce terme n'est aucunement limitatif de la nature et de la fonction de cette couche. Les termes « substrat », «couche à graver » et «couche sous-jacente » sont ainsi équivalents.

Le substrat 410 est par exemple en silicium 410.

La couche de masquage 420 est une couche dans laquelle on peut former des motifs par l'un quelconque des procédés de lithographie tels que : photolithographie ou impression nanométrique.

Dans les exemples suivant, décrits en référence aux figures 4 à 7, la couche de masquage 420 est un masque dur ou une couche de résine imprimable ou photosensible.

De manière plus générale, on qualifie de résine un matériau organique ou organo-minéral pouvant être mis en forme par une exposition à un faisceau d'électrons, de photons ou de rayons X ou mécaniquement. On peut citer à titre d'exemple des résines classiquement employées en microélectronique, des résines à base de polystyrène (PS), de méthacrylate (par exemple le Polymethyl methacrylate PMMA), d'Hydrosilsesquioxane (HSQ), de polyhydroxystyrène (PHS) etc. L'intérêt d'utiliser une résine est qu'il est facile d'en déposer une épaisseur importante, de plusieurs centaines de nanomètres à plusieurs microns.

La couche de masquage 420 déposée sur le substrat 410 présente, selon cet exemple de réalisation, une épaisseur 423 allant de 50 nanomètres (nm = 10⁻⁹ mètre) à quelques microns (micron ou µm = 10⁻⁶ mètre). L'épaisseur de cette couche de masquage 420, par exemple en résine, dépend de la forme et des dimensions critiques finales de la structure souhaitée.

La définition des motifs initiaux 421 dans la résine 420 se fait à l'aide d'étapes de photolithographie conventionnelle utilisant, par exemple, des équipements d'insolation fonctionnant dans l'ultra-violet (UV) c'est-à-dire de type : I-line 365 nm, DUV 248 nm, DUV 193 nm, ou toute autre technique de lithographie, par exemple, à faisceaux d'électrons ou e-beam, auto-alignée ou DSA, ou encore la lithographie par nano impression. Le choix est fait en fonction de la complexité et des dimensions des motifs initiaux 421 à former.

Si la couche de masquage 420 est un masque dur par exemple en SiO2, en SiN ou en TiN, on utilise également les techniques conventionnelles pour définir le motif initial 421 qui sera ensuite recouvert d'une couche tampon 430a-430n avant chaque implantation 500b-500n.

Typiquement on dépose une couche de résine sur la couche de masquage 420 formant un masque dur, puis on définit un motif initial par photolithographie ou par nano-impression dans cette résine avant de transférer ce motif initial dans la couche de masquage 420 formant un masque dur.

Comme cela sera décrit par la suite, selon un mode de réalisation optionnel, la structure comprend une couche intercalaire 610 située entre la couche de masquage 420 et la couche à graver 410.

Comme montré sur la figure 4a on procède à une première implantation 500a de tout type d'espèces permettant de modifier l'état du matériau de la couche à graver 410.

Les paramètres d'implantation, en particulier l'énergie communiquée aux ions, la durée et la dose d'implantation, sont prévus de sorte que les zones implantées 411a-411n puissent être gravées sélectivement par rapport aux zones non-implantées 412.

L'implantation consiste à implanter dans la couche à graver 410 des ions sans provoquer de dislocation de sa structure atomique telle qu'elle entraînerait une pulvérisation de la matière implantée.

Selon un mode de réalisation privilégié, l'implantation 500a permet de rendre amorphe le substrat 410 au droit des motifs initiaux 421 qui ont été définis dans la couche de masquage 420.

Il s'agit typiquement, comme déjà mentionné plus haut, d'une implantation d'ions à partir d'hydrogène (H2) qui entraîne une modification du matériau de la zone 411. On pourra également utiliser l'argon (Ar), l'azote (N2) ou l'hélium (He).

L'implantation est réalisée de manière anisotrope, de préférence selon au moins une direction d'implantation (axe Z sur les figures 4a-4h) sensiblement perpendiculaire au plan (XY sur les figures 4a-4h) dans lequel s'étend la couche à graver 410 ou un substrat sur lequel est disposée la couche à graver 410.

L'épaisseur du motif 421, la nature de la couche de masquage 420 et les paramètres de l'implantation 500a sont de préférence choisis de manière à empêcher, au droit du motif 421, la modification de la couche à graver 410. Ainsi, au droit du motif 421, c'est-à-dire sous le motif 421 selon la direction Z, les ions ne traversent pas la couche de masquage 420 pour pénétrer dans la couche à graver 410.

Selon un mode de réalisation, le matériau de la couche de masquage empêche aux ions de la traverser. Selon un autre mode de réalisation, c'est l'épaisseur de la couche de masquage qui est réglée de manière à ce que les ions restent piégés en son sein sans pénétrer dans la couche à graver sous-jacente. Dans le mode de réalisation dans lequel une couche intercalaire 610 est située entre la couche de masquage 420 et la couche à graver 410, c'est l'épaisseur de cette couche intercalaire qui peut être réglée afin d'éviter que la couche à graver 410 soit modifiée au droit des motifs 421. Il s'agit d'un premier avantage de cette couche intercalaire. Un autre avantage sera décrit ci-dessous.

Ainsi, les ions modifient la couche à graver 410 de préférence uniquement sur des zones qui ne sont pas au droit des motifs 421 formées dans la couche de masquage 420.

Selon un mode de réalisation alternatif, les ions modifient la couche à graver 410 même au droit des motifs 421 formées dans la couche de masquage 420. Néanmoins la profondeur d'implantation au droit des motifs 421 est inférieure à la profondeur d'implantation e500a des zones qui ne sont pas situées sous les motifs 421.

En ce qui concerne l'équipement d'implantation, plusieurs choix sont possibles :
- on peut par exemple utiliser un réacteur de gravure sèche dans lequel on forme un plasma et plus particulièrement ceux dits à couplage inductif ou capacitif ;
- ou alors un implanteur classique dit à ligne de faisceau ;
- ou encore un implanteur par immersion qui combine les deux techniques précédentes.
- Le choix de l'implanteur dépend du type de structure à réaliser et surtout de la profondeur e500-e500n à implanter dans le substrat 410.

Dans la description qui suit, on désigne par profondeur d'implantation la distance maximale entre la face supérieure du substrat 410 et la profondeur maximale à laquelle les ions sont implantés avec une concentration suffisamment élevée pour que la zone modifiée (411a, 411b,.., 411n) par implantation puisse être gravée sélectivement aux zones non implantées 412, ceci a un ratio de différence de vitesse de gravure strictement supérieure à 2 de préférence supérieure à 10.

La profondeur est mesurée selon la direction Z. Elle est référencée e500a s'il s'agit de la profondeur obtenue à l'issue de l'étape d'implantation 500a. Elle est référencée e500n s'il s'agit de la profondeur obtenue à l'issue de l'étape d'implantation 500n.

Dans le cas d'utilisation d'un réacteur de gravure, la profondeur d'implantation des ions est limitée à quelques dizaines de nanomètres. Typiquement, l'implantation peut se faire sur une profondeur allant de quelques Angstrôms (10⁻¹⁰ mètres) jusqu'à un maximum de 100 nm. Une implantation en formant un plasma de type CH4/He, c'est-à-dire méthane/hélium, dans une proportion de 1/50 de ces composés, est dans ce cas préférée car ce type de plasma offre une sélectivité de gravure infinie vis-à-vis de la résine (aucune gravure significative n'est observée pendant l'implantation) dans le cas où la couche de masquage 420 est en résine. Dans le cas où l'on utilise de l'hydrogène, on observe au contraire que celui-ci réagit chimiquement avec la résine et la grave pendant l'implantation altérant ainsi les dimensions des motifs préalablement définis par photolithographie comme on l'a vu ci-dessus. Par ailleurs, l'avantage d'utiliser un réacteur de gravure pour l'implantation est que la modification du substrat, son amorphisation, se fait sans discontinuité sur toute la profondeur e500 implantée, c'est-à-dire depuis la surface du substrat 410 jusqu'à la profondeur maximale de la zone implantée. Ainsi l'étape de nettoyage qui va suivre et qui est décrite ci-après est très efficace pour retirer tout le film modifié.

Avec un implanteur classique on peut implanter des ions à une profondeur plus élevée, qui peut atteindre plusieurs centaines de nanomètres. Néanmoins, l'inconvénient des implanteurs classiques réside dans le fait qu'il est difficile d'implanter en surface. En effet avec les implanteurs classiques il existe une énergie minimale de l'ordre de 1 keV (kilo électronvolt) qui provoque inévitablement une pénétration des ions implantées dans le substrat. Les ions se trouvent donc à distance de la surface de ce dernier, même si cela reste à faible profondeur. Il existe ainsi une zone entre la surface et cette profondeur dépourvue ou avec un très faible taux d'espèce implantée. Cela ne permet donc pas qu'une modification en surface, de l'ordre de quelques nanomètres, puisse se faire.

La profondeur minimale d'implantation dans ces conditions est d'environ 20 nm pour des ions hydrogène et de 5 nm pour une implantation à partir d'azote.

La modification de la couche à graver 410 ne s'effectue alors pas de manière parfaitement continue depuis la surface de cette couche.

Des profils d'implantation d'ions hydrogène obtenus, d'une part, à partir d'un plasma dans un réacteur de gravure 510 et, d'autre part, dans un implanteur classique 520, sont représentés pour comparaison sur la **figure 5****.** Dans le premier cas, on notera que la concentration d'ions décroit linéairement 512 depuis la surface où elle est donc la plus élevée. En réglant le plasma pour que les ions acquièrent une plus forte énergie, on atteint des profondeurs plus élevées avec toujours un profil linéaire décroissant 514.

Dans le cas d'un implanteur classique 520, l'implantation se fait autour d'une profondeur moyenne (Rp) où la concentration est maximale avec un profil gaussien de part et d'autre 522. Il faut alors procéder à plusieurs implantations à des énergies différentes et donc des profondeurs différentes (Rp1, Rp2) pour couvrir toute l'épaisseur à modifier du substrat. Des doses plus élevées permettent d'augmenter la concentration 524 des ions implantés. Avec une même dose, on atteint des profondeurs plus élevées 526 en communiquant aux ions une énergie plus grande. De manière conventionnelle, la dose exprime le nombre d'atomes implantés dans la matière par centimètres carrés.

Dans le cadre de la présente invention, on pourra utiliser les méthodes connues de l'homme du métier et les logiciels (SRIM, TRIM, CTRIM...) qui permettent de simuler en fonction des conditions d'implantations (espèces implantées, matériau implanté, dose, énergie, temps d'exposition de la plaque au faisceau d'ions etc.) l'implantation résultante et notamment la profondeur d'implantation.

Une solution permettant d'utiliser un implanteur classique et ainsi de pallier le problème des faibles énergies délivrées par ce type d'équipement est, comme évoqué ci-dessus, d'ajouter une « couche intercalaire » 610 ou « buffer layer » 610 entre la couche de masquage 420 et le substrat 410.

L'épaisseur de la couche intercalaire 610, qui est au minimum 30 nm, permet alors d'implanter jusqu'en surface le substrat 410 même avec des ions accélérés avec une énergie de seulement 1keV. Dans ce type de réacteur, l'implantation est réalisée à une profondeur donnée, notée Rp comme précédemment. Autour de cette profondeur Rp, la zone d'implantation s'étale typiquement sur quelques dizaines de nanomètres. Pour obtenir une modification continue du substrat 410, depuis sa surface jusqu'à la profondeur souhaitée, il est alors nécessaire d'assurer un recouvrement des profondeurs e500a-e500n modifiées du substrat 410 après chaque étape d'implantation 500a-500n.

Ainsi lors de l'implantation de la couche à graver, faite par exemple en silicium, la couche intercalaire 610 recouvre la couche à graver 410.

Selon un mode de réalisation la couche intercalaire 610 est en matériau carboné tel que de la résine.

Selon un autre mode de réalisation la couche intercalaire 610 est en un matériau non carboné, tel que par exemple le SiARC (revêtement anti-réfléchissant) ou le SixOy (SiO2 par exemple) ou le SixNy (SiN par exemple), ou encore un masque métallique tel que le TiN. Dans le cas du SiARC elle présente par exemple une épaisseur de 100 nm pour une implantation dans le silicium constituant le substrat 410 qui s'étend sur une profondeur 413a de 350 nm. Dans ce cas la couche de masquage 420 est de préférence en résine.

Ce mode de réalisation avec couche intercalire présente un avantage considérable. En effet, il s'est avéré que les implantations 500a-500n en l'absence d'une couche intercalaire 610, en particulier à travers une couche de masquage 420 carbonée telle qu'une couche de résine, induit un phénomène qui diminue le contrôle dimensionnel de la forme obtenue au final et qui dégrade la qualité du matériau de la couche à graver 410.

Plus précisément, en l'absence d'une couche intercalaire 610, lorsque la couche de masquage 420 est carbonée, l'implantation recherchée dans la couche à graver 410 produit inévitablement un déplacement des atomes de carbone initialement présents dans la couche de masquage 420 jusque dans la couche à graver 410. Dans le cadre du développement de la présente invention, il s'est avéré que ces atomes de carbone forment alors dans la couche à graver 410 un film de surface enrichi en carbone. Ce film présente généralement une épaisseur inférieure à 20 nm et plus souvent inférieure à 10nm en fonction de l'énergie du bombardement.

Ainsi, la surface de la couche à graver 410 est modifiée par l'apport de carbone. Du fait de cette modification de la surface de la couche à graver, il n'est alors plus possible de venir correctement graver par gravure humide la zone implantée 411.

En effet une gravure humide par une solution d'hydroxyde d'ammonium tétra-méthyle (TMAH) ou d'acide fluorhydrique (HF) par exemple, ne permettra pas de retirer les zones modifiées par implantation si elles ont été enrichies en carbone. Il s'ensuit que les motifs de la couche de masquage ne sont pas fidèlement reproduits dans la couche à graver. En particulier, les flancs des motifs de la couche à graver 410 ne sont pas situés au droit de ceux de la couche de masquage 420. Par ailleurs, les flancs des motifs de la couche à graver 410 ne sont pas verticaux.

Le contrôle dimensionnel de la forme complexe à réaliser est donc fortement dégradé.

Dans un cas plus extrême, la solution de gravure ne parvient pas à graver la couche à graver 410 de silicium si la surface de cette dernière a été trop enrichie en carbone.

La couche intercalaire 610 protège la couche à graver 420 de tout apport de carbone. En effet lors de l'implantation, le carbone est stoppé par la couche intercalaire 610. L'épaisseur de cette dernière est choisie de manière à ce que les atomes de carbone ne la traversent pas. Ainsi la couche intercalaire piège les atomes de carbone.

Un autre mode de réalisation qui permet d'éviter l'apport de carbone dans la couche à graver 410 et qui permet donc d'améliorer le contrôle dimensionnel des motifs finaux, comprend l'utilisation d'une couche de masquage 420 formant un masque dur non carboné à la place d'une couche de masquage carbonée.

Il peut s'agir d'un masque dur inorganique, par exemple en SiOx ou en SiNx et plus particulièrement en SiO2 ou SiN. Il peut également s'agir d'un masque dur métallique, par exemple en TiN.

Ce masque dur n'étant pas carboné, il ne transfert pas d'atomes de carbone dans la couche à graver 420 lors de l'implantation. Il ne se forme alors pas à la surface de cette dernière un film enrichi en carbone.

Ces deux modes de réalisation, utilisant une couche intercalaire 610 et un masque dur ont pour avantage de permettre un retrait des zones modifiées de la couche à graver par TMAH.

Un avantage d'une gravure humide est d'avoir une meilleure sélectivité de gravure avec la partie non implantée qu'avec d'autres types de gravure notamment par plasma. Une gravure par plasma est en effet beaucoup plus agressive du fait du bombardement. L'invention permet d'obtenir un meilleur contrôle dimensionnel de la forme complexe réalisée et une meilleure qualité du matériau résiduel de la couche à graver 610.

En se référant à la figure 4b, à l'issue de la première étape d'implantation 500, on obtient donc dans le substrat 410 :
- Des zones modifiées 411a par implantation sur une profondeur e500a. Ces zones ne sont pas situées à l'aplomb des motifs 421.
- Des zones non modifiées 412 situées à l'aplomb des motifs 421. Ces zones non modifiées 412 s'étendent depuis la surface du substrat 410 comme illustré sur la figure 4b. Alternativement, et en fonction des conditions d'implantation (énergie des ions et nature des ions notamment), de l'épaisseur du motif 421 et de la nature de la couche de masquage 420, il est possible qu'une portion superficielle du substrat 410 soit modifiée. La profondeur de cette modification sera inférieure à la profondeur e500a des zones modifiées 411a situées en dehors des motifs 421.

L'interface 412a entre zones 411a modifiées et zones 412 non modifiées, ou modifiées sur une profondeur moindre, est située à l'aplomb des flancs 422 du motif 421, comme illustré en figure 4b, si la direction privilégiée d'implantation 500 est perpendiculaire au plan du substrat 410.

La figure 4c illustre une étape de dépôt d'une couche tampon 430a. Cette couche tampon 430a recouvre la couche de masquage 420, de préférence entièrement. Elle recouvre en particulier le motif 421.

La couche tampon 430a recouvre notamment les flancs 422 du motif 421 et de préférence également son sommet.

De préférence la couche tampon 430a est une couche conforme. Son épaisseur est donc constante sur toute la surface de l'empilement, cette épaisseur étant mesurée, en chaque point perpendiculairement à la surface de la couche de masquage 420. Ainsi la couche tampon 430a reproduit le profil de la couche de masquage 420. En particulier, l'épaisseur e₁430a (prise selon l'axe Z) de la couche tampon 430a en dehors d'un motif 421 est identique à l'épaisseur e₂430a (prise selon l'axe X) de la couche tampon 430a sur un flanc 422 du motif 421.

La couche tampon 430a est par exemple à base de carbone. Elle est par exemple dans ce cas faite de carbone. Alternativement, la couche tampon 430a est à base de silicium. Elle est, par exemple dans ce cas, en nitrure tel que le nitrure de silicium (SiN) ou en oxyde de silicium (SiOₓ) tel que le dioxyde de silicium (SiO₂).

De préférence pour obtenir ce dépôt conforme le dépôt de la couche tampon 430a est réalisé dans un réacteur de dépôt par exemple à l'aide de l'un des procédés suivants : PECVD, acronyme de l'anglais « plasma-enhanced chemical vapor déposition » signifiant dépôt chimique en phase vapeur assisté par plasma, LPCVD, acronyme de l'anglais « low-pressure chemical vapor déposition » signifiant dépôt chimique en phase vapeur à basse pression, ALD acronyme de l'anglais « atomic layer déposition » signifiant dépôt par couche atomique, ou PEALD acronyme de l'anglais « plasma enhanced atomic layer déposition» signifiant dépôt par couche atomique assisté par plasma.

Le dépôt peut être également obtenu dans un réacteur de gravure en utilisant des gaz de type CxFyHz, CxHy si l'on souhaite obtenir une couche tampon à base de carbone (C), ou des gaz de type SiCl4, SiF4 ou SiH4 si l'on souhaite obtenir une couche tampon à base de silicium (Si). L'avantage de réaliser ce type de dépôt dans un réacteur de gravure est que l'on peut réaliser les deux étapes (implantation et dépôt) dans le même réacteur et ainsi avoir un gain de productivité.

Comme illustré en figure 4d, après avoir formé la couche tampon 430a, on effectue une étape d'implantation 500b à travers la couche tampon 430a et la couche de masquage 420 pour modifier la couche à graver 410.

Cette implantation 500b est effectuée sur une profondeur e500b supérieure à la profondeur e500a. Ainsi de nouvelles zones 411b de la couche à graver 410 sont modifiées. De préférence, ces nouvelles zones modifiées 411b chevauchent ou recouvrent en partie (selon la direction d'implantation Z) les zones 411a de manière à ce que la couche à graver 410 soit modifiée en continu entre les différentes zones 411a-411b modifiées.

Selon l'axe X, l'interface 412b entre zones 411b modifiées et zones 412 non modifiées, ou modifiées sur une profondeur moindre, est située à l'aplomb des flancs 431a de la couche tampon 430a recouvrant le motif 421 comme illustré en figure 4d, si la direction privilégiée d'implantation 500b est perpendiculaire au plan du substrat 410. La distance, selon l'axe X, entre cette interface 412b et l'interface 412a entre zones modifiées 411a et zone non modifiée 412 correspond à l'épaisseur e₂430a de la couche tampon 430a recouvrant les flancs 422 des motifs 421.

Ainsi, en se référant à la figure 4d, à l'issue de la deuxième étape d'implantation 500b, on obtient donc dans la couche à graver 410 :
- Des zones modifiées 411a et 411b par implantation sur une profondeur e500a et e550b. Ces zones ne sont pas situées à l'aplomb des motifs 421.
- Des zones non modifiées 412, situées à l'aplomb des motifs 421 sur la profondeur e500a et situées à l'aplomb des flancs 431a sur une profondeur comprise entre la profondeur e500a et la profondeur e500b.

Ainsi, c'est bien la même couche de masquage 420 qui est conservée entre deux étapes d'implantation 500a, 500b. De même, c'est bien le même motif 421 utilisé lors d'une première étape d'implantation 500a qui est conservé avant d'effectuer le dépôt de la couche tampon 430a et une deuxième étape d'implantation 500b. Après implantation au droit d'un motif porté par la couche de masquage 420, il n'y a donc pas de retrait de cette couche de masquage 420 pour en redéposer une autre portant un autre motif. La même couche de masquage 420 est conservée et l'au moins un motif 421 qu'elle porte est élargi s'il est en relief ou est rétréci s'il est en creux par le dépôt de la couche tampon 430.

Ainsi, les motifs à travers lesquels les implantations successives sont effectuées sont tous auto-alignés sur les motifs initiaux 421, ce qui confère une précision accrue pour les dimensions obtenues au final.

On notera que la différence de profondeur entre les profondeurs e500a et e500b n'est pas nécessairement identique l'épaisseur e₁430a de la couche tampon 430a. Ce mode de réalisation apparaît sur la figure 4d. Cela est par exemple dû à nature de la couche tampon 430a à travers laquelle les ions pénètrent plus facilement qu'à travers la couche de masquage 420. Cela peut également être dû à une modification de l'énergie d'implantation des ions.

Comme illustrée en 4e, de préférence on réalise ensuite une succession d'étapes dépôt/implantation pour aboutir à la structure finale souhaitée.

Plus en détail, les opérations précédentes, de dépôt d'une couche tampon 430n puis d'implantation 500n, peuvent être répétées à partir du motif initial 421 afin d'obtenir un profil d'implantation des ions dans le substrat 410 en marches d'escalier 450 comme le profil illustré sur la figure 4h. En agissant sur les épaisseurs des couches tampon 430a-430n et d'implantation 500a-500n à chacune des étapes on peut obtenir des profils avec des rapports de forme très différents.

Sur la figure 4e, les zones modifiées par implantation après chaque nouveau dépôt d'une couche tampon 430 sur la couche de masquage 420 sont référencées 411a-411n. Naturellement au cours de l'implantation de la zone 411n, une partie supérieure des zones 411a-411c modifiées au cours des étapes précédentes d'implantation est à nouveau implantée, l'implantation étant effectuée pleine plaque.

Comme illustré en figure 4e, l'interface 412n entre zones 411n modifiées et zones 412 non modifiées, ou modifiées sur une profondeur moindre, est située à l'aplomb des flancs 431n de la couche tampon 430n recouvrant le motif 421.

Naturellement, toutes les caractéristiques et étapes énoncées à propos de la couche tampon 430a sont valables pour les autres couches tampon 430b.., 430n.

Deux modes de réalisation notamment sont envisageables.

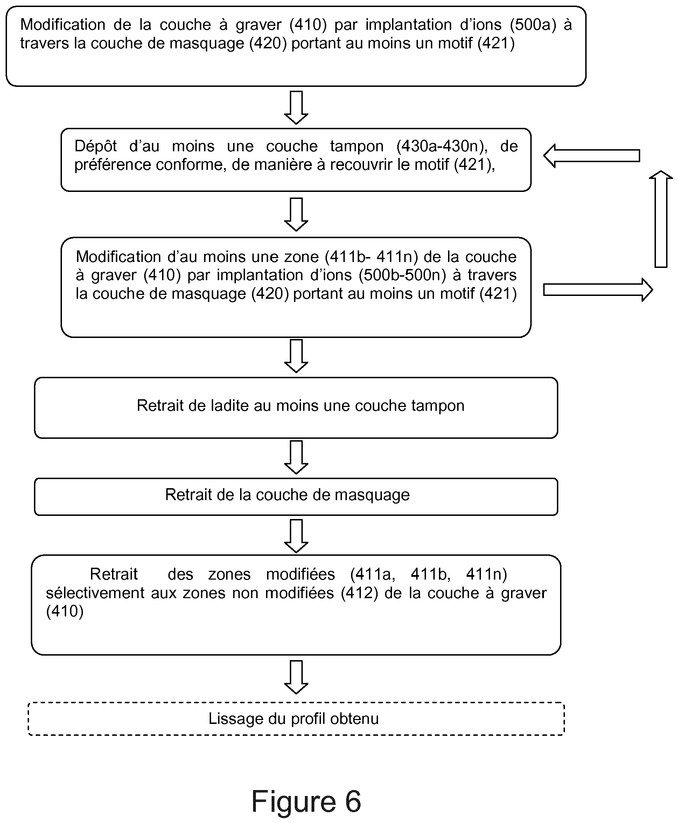

Selon le mode de réalisation, décrit par la figure 6, après chaque implantation 500i à travers une couche tampon 430i, cette couche tampon 430i est conservée et la couche tampon suivante 430i+1 est déposée sur la couche tampon précédente 430i.

Ainsi l'épaisseur totale de la couche formée par l'empilement des couches tampon augmente automatiquement à chaque nouvelle séquence, chaque séquence comprenant une étape de dépôt et une étape d'implantation.

Selon ce mode de réalisation, il est alors possible de déposer des couches tampon 430i d'épaisseur identique à chaque séquence.

Ce mode de réalisation présente aussi pour avantage de n'avoir qu'une seule étape de retrait pour l'ensemble des couches tampon 430a-430n déposées.

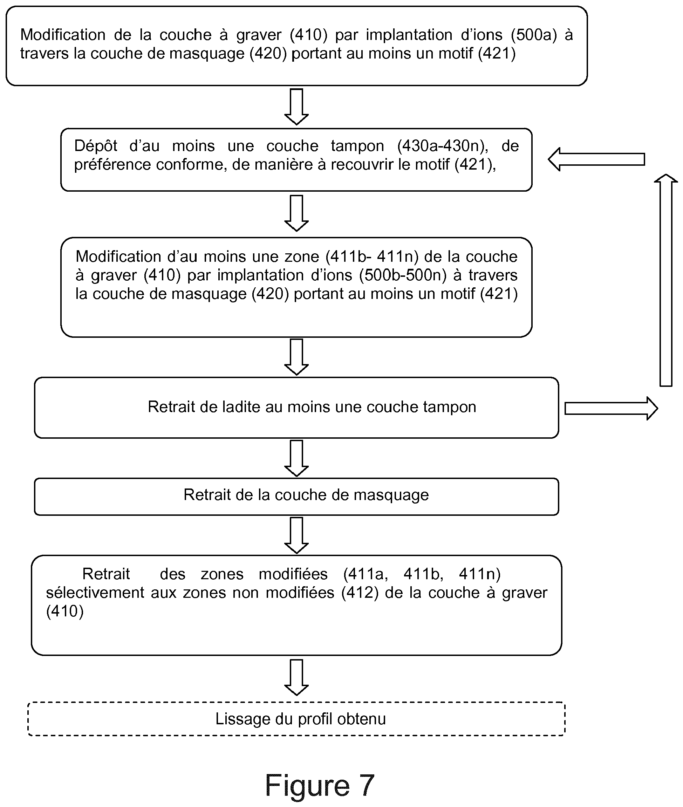

Selon un autre mode de réalisation, décrit par la figure 7, après chaque implantation 500i à travers une couche tampon 430i, cette couche tampon 430i est retirée. La couche tampon suivante 430i+1 est alors déposée sur la couche de masquage 420. Cette nouvelle couche tampon 430i+1 doit alors présenter une épaisseur supérieure à celle de la couche tampon précédente 430i. Ainsi, selon ce mode de réalisation chaque séquence comprend une étape de dépôt d'une couche tampon, une étape d'implantation à travers cette couche tampon et une étape de retrait de cette couche tampon.

À l'étape suivante illustrée en figure 4f, quand on a obtenu le profil souhaité, on procède au retrait de l'empilement de couches tampon 430a-430n déposées successivement (mode de réalisation de la figure 6) ou de l'unique couche tampon 430n si les couches tampon successives 430a-430n sont retirées après chaque implantation (mode de réalisation de la figure 7).

L'étape du retrait de cet empilement de couches tampons ou de chaque couche tampon 430a-430n, lorsque la couche tampon forme un masque dur est obtenue de préférence par voie humide.

Par exemple on utilise une chimie HF si le matériau de la couche tampon est du SiO2 ou du SiN. On utilise une chimie H3PO4 si le matériau de la couche tampon est du SiN.

Si le matériau de la couche tampon est à base de carbone, le retrait est réalisé dans une chambre de gravure en utilisant une chimie oxydante ou réductrice.

Comme illustré en figure 4g, retire ensuite la couche de masquage 420. Cette étape est parfaitement connue et maitrisée par l'homme du métier. Lorsque la couche de masquage 420 est en résine son retrait est classiquement réalisée dans une chambre de gravure en utilisant une chimie à base d'oxygène ou par voie humide en utilisant une chimie couramment employée dite SPM(H2SO4:H2O2) à base d'acide sulfurique (H2SO4) et d'eau oxygénée (H2O2).

Au cours de cette même étape ou par une étape additionnelle on retire également la couche intercalaire 610 si elle est présente.

La figure 4h illustre le résultat de l'étape suivante où l'on procède au retrait de toute les zones 411a-411n du substrat qui ont été modifiées, c'est-à-dire le plus souvent amorphisée, par les opérations successives d'implantation 500a-500n d'ions.

Les zones 411a-411n modifiées, laissent place, après leur retrait aux cavités 450 qui définissent sur cet exemple non limitatif un profil en marche d'escalier.

Les conditions de retrait des zones modifiées 411a-411n, sont choisies pour qu'il n'y ait pas ou peu de consommation des zones non modifiées 412 du substrat 410, c'est à dire avec une consommation du matériau non modifié qui n'excède pas quelques nanomètres par minute. Typiquement, si le substrat 410 est fait de silicium cristallin, on procède au retrait du silicium amorphisé par les implantations, sélectivement au silicium cristallin, en utilisant une solution d'hydroxyde d'ammonium tétra-méthyle (TMAH) ou d'acide fluorhydrique (HF) sous atmosphère d'oxygène. Le silicium cristallin n'est pas ou peu consommé par ce type de nettoyage.

La figure 4h illustre également le résultat d'un lissage des profils en marches d'escalier qui peut être effectué après l'étape précédente de retrait du silicium amorphisé. Cette étape de lissage est optionnelle. Elle est donc encadrée en pointillée sur les figures 6 et 7.

Le profil obtenu après lissage est référencé 700. Pour ce lissage on procède à une oxydation thermique du silicium du substrat 410 afin de former une couche d'oxyde dans une gamme d'épaisseur allant par exemple de 10 nm à 2 µm. Cette opération de croissance d'oxyde thermique est suivie d'une désoxydation et nettoyage par exemple par voie humide dans une solution d'acide fluorhydrique (HF). En fonction de l'épaisseur d'oxyde de silicium que l'on souhaite réaliser les conditions de croissance de cet oxyde thermique pourront être par exemple les suivantes :
- oxydation thermique d'épaisseur 200 nm à l'aide d'un recuit à 1000°C sous atmosphère oxydante pendant 20 minutes ;
- oxydation thermique d'épaisseur 1000 nm à l'aide d'un recuit à 1000°C sous atmosphère oxydante pendant 3 heures.
Le retrait du SiO2 ainsi formé pourra se faire par dissolution de l'oxyde par voie humide dans une solution d'acide fluorhydrique (HF) diluée à 10%.

Cette étape permet avantageusement d'obtenir un lissage des parois du profil ainsi formé et/ou d'adapter plus précisément ses dimensions finales.

Ce profil est par exemple apte à former un moule, dont une application possible est la réalisation par impression nanométrique d'une lentille asphérique.

Comme indiqué ci-dessus l'invention est particulièrement avantageuse dans le cas où la couche à graver 410 est en silicium ou dans l'un des matériaux suivants : le silicium germanium, le germanium, le nitrure de silicium, le saphir, le quartz, le verre.

Selon encore un autre mode de réalisation la couche à graver 410 est en oxyde de silicium carboné et hydrogéné (SiOCH). Il peut s'agir de SiOCH poreux ou dense. Ce matériau présente pour avantage d'avoir une très faible permittivité, en particulier lorsqu'il est poreux.

Tous les modes de réalisation décrits ci-dessus sont applicables au SiOCH.

Au vu de la description qui précède, il apparaît clairement que l'invention propose une solution simple, fiable et aisément industrialisable pour réaliser des profils possiblement complexes et nécessitant d'aligner plusieurs opérations de lithographies.

L'invention n'est pas limitée aux modes de réalisations précédemment décrits et s'étend à tous les modes de réalisation couverts par les revendications.

## Revendications

1. Procédé de réalisation de motifs dans une couche à graver (410), à partir d'un empilement comprenant au moins la couche à graver (410) et une couche de masquage (420) surmontant la couche à graver (410), la couche de masquage (420) présentant au moins un motif (421), le procédé étant **caractérisé en ce qu'**il comprend au moins:
a) une étape de modification d'au moins une première zone (411a) de la couche à graver (410) par implantation d'ions (500a) à travers la couche de masquage (420);
b) au moins les étapes suivantes:
b1) une étape de dépôt d'au moins une couche tampon (430a-430n) de manière à recouvrir au moins le motif (421) de ladite couche de masquage (420);
b2) une étape de modification d'au moins une autre zone (411b-411n) de la couche à graver (410), différente de la première zone (411a), par implantation d'ions (500b-500n) à travers ladite couche tampon (430a-430n), l'implantation étant effectuée jusqu'à une profondeur (e500b-e500n) de la couche à graver (410) supérieure à la profondeur (e550a) d'implantation de l'étape précédente de modification ;
c) au moins une étape de retrait de ladite au moins une couche tampon (430a-430n) ;
d) une étape de retrait de la couche de masquage (420) ;
e) une étape de retrait des zones modifiées (411a-411n), le retrait comprenant une étape de gravure des zones modifiées (411a-411n) sélectivement aux zones non modifiées (412) de la couche à graver (410).

2. Procédé selon la revendication précédente, dans lequel l'étape de dépôt de la couche tampon (430a-430n) est un dépôt conforme.

3. Procédé selon l'une quelconque des revendications précédentes, dans lequel, avant l'étape c) de retrait de ladite au moins une couche tampon (430a-430n), on effectue plusieurs fois, de préférence au moins deux fois et de préférence au moins trois fois, une séquence d'étapes, chaque séquence comprenant les étapes b1) et b2), une couche tampon déposée lors d'une séquence donnée s'empilant ainsi sur une couche tampon déposée lors d'une séquence précédent la séquence donnée.

4. Procédé selon l'une quelconque des revendications 1 à 2, dans lequel, avant l'étape d) de retrait de la couche de masquage (420), on effectue plusieurs fois, de préférence au moins deux fois et de préférence au moins trois fois, une séquence d'étapes, chaque séquence comprenant les étapes b1), b2) et c) et dans lequel une couche tampon déposée lors d'une séquence donnée présente une épaisseur supérieure à l'épaisseur d'une couche tampon déposée lors d'une séquence précédent la séquence donnée.

5. Procédé selon la revendication précédente dans lequel ladite étape de gravure utilise une solution à base d'hydroxyde d'ammonium tétra-méthyle (TMAH) ou d'acide fluorhydrique (HF), de préférence sous atmosphère d'oxygène.

6. Procédé selon l'une quelconque des revendications précédentes dans lequel l'empilement comprend une couche intercalaire (610) disposée entre la couche de masquage (420) et la couche à graver (410) et recouvrant la couche à graver (410) lors de l'implantation.

7. Procédé selon la revendication précédente dans lequel la couche de masquage (420) comprend du carbone et dans lequel l'épaisseur de la couche intercalaire (610) est suffisante pour former une barrière empêchant, lors des implantations (500a-500n), à des espèces carbonées provenant de la couche de masquage (420) de pénétrer à l'intérieur de la couche à graver (410).

8. Procédé selon l'une quelconque des deux revendications précédentes dans lequel l'épaisseur de la couche intercalaire (610) est réglée de manière à ce qu'au niveau des zones modifiées (411a, 411b, 411n) les ions soient implantés en continu depuis la surface de la couche à graver (410).

9. Procédé selon l'une quelconque des revendications 1 à 6, dans lequel la couche de masquage (420) est une résine ou est une couche formant un masque dur, dont le matériau est de préférence pris parmi l'un ou une combinaison des matériaux suivants : le carbone, SiOx, le SiNy, le SiARC et le TiN.

10. Procédé selon l'une quelconque des revendications précédentes dans lequel au moins l'une des implantations (500a-500n) est effectuée avec un implanteur.

11. Procédé selon l'une quelconque des revendications 1 à 9 dans lequel au moins l'une des implantations (500a-500n) est effectuée dans un réacteur plasma.

12. Procédé selon l'une quelconque des revendications précédentes dans lequel les étapes b1) et b2) sont choisies, en particulier l'épaisseur de la couche tampon (430a-430n) et la profondeur d'implantation, de manière à ce que les zones modifiées (411a, 411b, 411n) forment un profil en marches d'escalier.

13. Procédé selon la revendication précédente dans lequel après gravure d'un profil en marches d'escalier dans la couche à graver (410) on procède à un lissage dudit profil par oxydation et désoxydation du matériau de la couche à graver (410).

14. Procédé selon l'une quelconque des revendications précédentes dans lequel la couche à graver (410) est une couche ou un substrat dont le matériau est pris parmi : le silicium, le silicium germanium, le germanium, le nitrure de silicium, le saphir, le quartz, le verre, le SiOCH, le SiOCH poreux.

15. Procédé selon l'une quelconque des revendications précédentes dans lequel ladite au moins une couche tampon (430a-430n) est à base de nitrure de silicium (SiN) ou à base d'oxyde de silicium (SiOₓ) tel que le dioxyde de silicium (SiO₂).

## Patentansprüche

1. Verfahren zum Ausführen von Mustern in einer Schicht (410), die geätzt werden soll, ausgehend von einem Stapel, der mindestens die zu ätzende Schicht (410) und eine Maskierschicht (420) umfasst, welche die zu ätzende Schicht (410) überdeckt, wobei die Maskierschicht (420) mindestens ein Muster (421) aufweist, wobei das Verfahren **dadurch gekennzeichnet ist, dass** es mindestens umfasst:
a) einen Schritt des Modifizierens von mindestens einer ersten Zone (411a) der zu ätzenden Schicht (410) durch Implantation von Ionen (500a) durch die Maskierschicht (420) hindurch;
b) mindestens die folgenden Schritte:
b1) einen Schritt des Abscheidens von mindestens einer Pufferschicht (430a-430n), um mindestens das Muster (421) der Maskierschicht (420) abzudecken;
b2) einen Schritt des Modifizierens von mindestens einer anderen Zone (411b-411n) der zu ätzenden Schicht (410), die sich von der ersten Zone (411a) unterscheidet, durch Implantation von Ionen (500b-500n) durch die Pufferschicht (430a-430n) hindurch, wobei die Implantation bis zu einer Tiefe (e500b-e500n) der zu ätzenden Schicht (410) durchgeführt wird, die größer ist als die Implantationstiefe (e550a) des vorhergehenden Modifikationsschritts;
c) mindestens einen Schritt des Entfernens der mindestens einen Pufferschicht (430a-430n);
d) einen Schritt des Entfernens der Maskierschicht (420);
e) einen Schritt des Entfernens der modifizierten Zonen (411a-411n), wobei das Entfernen einen Schritt des Ätzens der modifizierten Zonen (411a-411n) selektiv zu den nicht modifizierten Zonen (412) der zu ätzenden Schicht (410) umfasst.

2. Verfahren nach dem vorstehenden Anspruch, wobei der Schritt des Abscheidens der Pufferschicht (430a-430n) ein konformes Abscheiden ist.

3. Verfahren nach einem der vorstehenden Ansprüche, wobei vor dem Schritt c) des Entfernens der mindestens einen Pufferschicht (430a-430n) mehrmals, vorzugsweise mindestens zweimal und vorzugsweise mindestens dreimal eine Sequenz von Schritten durchgeführt wird, wobei jede Sequenz die Schritte b1) und b2) umfasst, wobei eine Pufferschicht, die bei einer gegebenen Sequenz abgeschieden wird, sich somit auf einer Pufferschicht stapelt, die bei einer Sequenz, welche der gegebenen Sequenz vorhergeht, abgeschieden wird.

4. Verfahren nach einem der Ansprüche 1 bis 2, wobei vor dem Schritt d) des Entfernens der Maskierschicht (420) mehrmals, vorzugsweise mindestens zweimal und vorzugsweise mindestens dreimal eine Sequenz von Schritten durchgeführt wird, wobei jede Sequenz die Schritte b1), b2) und c) umfasst, und wobei eine Pufferschicht, die bei einer gegebenen Sequenz abgeschieden wird, eine Dicke aufweist, die größer ist als die Dicke einer Pufferschicht, die bei einer Sequenz, welche der gegebenen Sequenz vorhergeht, abgeschieden wird.

5. Verfahren nach dem vorstehenden Anspruch, wobei der Ätzschritt eine Lösung auf Basis von Tetramethylammoniumhydroxid (TMAH) oder Fluorwasserstoffsäure (HF), vorzugsweise unter Sauerstoffatmosphäre, verwendet.

6. Verfahren nach einem der vorstehenden Ansprüche, wobei der Stapel eine Zwischenschicht (610) umfasst, die zwischen der Maskierschicht (420) und der zu ätzenden Schicht (410) angeordnet ist und die zu ätzende Schicht (410) bei der Implantation abdeckt.

7. Verfahren nach dem vorstehenden Anspruch, wobei die Maskierschicht (420) Kohlenstoff umfasst, und wobei die Dicke der Zwischenschicht (610) ausreichend ist, um eine Barriere zu bilden, die bei den Implantationen (500a-500n) Kohlenstoffspezies, welche aus der Maskierschicht (420) stammen, daran hindert, in das Innere der zu ätzenden Schicht (410) einzudringen.

8. Verfahren nach einem der zwei vorstehenden Ansprüche, wobei die Dicke der Zwischenschicht (610) so eingestellt wird, dass im Bereich der modifizierten Zonen (411a, 411b, 411n) die Ionen ab der Oberfläche der zu ätzenden Schicht (410) kontinuierlich implantiert werden.

9. Verfahren nach einem der Ansprüche 1 bis 6, wobei die Maskierschicht (420) ein Harz ist oder eine Schicht ist, die eine harte Maske bildet, dessen Material vorzugsweise aus einem oder einer Kombination der folgenden Materialien gewählt ist: Kohlenstoff, SiOx, SiNy, SiARC und TiN.

10. Verfahren nach einem der vorstehenden Ansprüche, wobei mindestens eine der Implantationen (500a-500n) mit einem Implanter durchgeführt wird.

11. Verfahren nach einem der Ansprüche 1 bis 9, wobei mindestens eine der Implantationen (500a-500n) in einem Plasmareaktor durchgeführt wird.

12. Verfahren nach einem der vorstehenden Ansprüche, wobei die Schritte b1) und b2), insbesondere die Dicke der Pufferschicht (430a-430n) und die Implantationstiefe, so ausgewählt werden, dass die modifizierten Zonen (411a, 411b, 411n) ein Treppenstufenprofil bilden.

13. Verfahren nach dem vorstehenden Anspruch, wobei nach dem Ätzen eines Treppenstufenprofils in die zu ätzende Schicht (410) mit einem Glätten des Profils durch Oxidieren und Desoxidieren des Materials der zu ätzenden Schicht (410) verfahren wird.

14. Verfahren nach einem der vorstehenden Ansprüche, wobei die zu ätzende Schicht (410) eine Schicht oder ein Substrat ist, dessen Material gewählt ist aus: Silizium, Silizium-Germanium, Germanium, Siliziumnitrid, Saphir, Quarz, Glas, SiOCH, porösem SiOCH.

15. Verfahren nach einem der vorstehenden Ansprüche, wobei die mindestens eine Pufferschicht (430a-430n) auf Basis von Siliziumnitrid (SiN) oder auf Basis von Siliziumoxid (SiOₓ), wie etwa Siliziumdioxid (SiO₂) ist.

## Claims

1. Method for producing patterns in a layer to be engraved (410), from a stack comprising at least the layer to be engraved (410) and a masking layer (420) surmounting the layer to be engraved (410), the masking layer (420) having at least one pattern (421), the method being **characterised in that** it comprises at least:
a) one step of modifying at least one first zone (411a) of the layer to be engraved (410) by implantation of ions (500a) through the masking layer (420);
b) at least the following steps:
b1) a step of depositing at least one buffer layer (430a-430n) so as to cover at least the pattern (421) of said masking layer (420);
b2) a step of modifying at least one other zone (411b-411n) of the layer to be engraved (410), different from the first zone (411a), by implantation of ions (500b-500n) through said buffer layer (430a-430n), the implantation being done up to a depth (e500b-e500n) of the layer to be engraved (410) greater than the depth (e550a) of implantation of the preceding modification step;
c) at least one step of removing said at least one buffer layer (430a-430n);
d) a step of removing the masking layer (420);
e) a step of removing the modified zones (411a-411n), the removal comprising a step of engraving the modified zones (411a-411n) selectively to the non-modified zones (412) of the layer to be engraved (410).

2. Method according to the preceding claim, wherein the step of depositing the buffer layer (430a-430n) is a conform deposit.

3. Method according to any one of the preceding claims, wherein, before step c) of removing said at least one buffer layer (430a-430n), several times, preferably at least twice and preferably less three times, a sequence of steps is carried out, each sequence comprising steps b1) and b2), a buffer layer deposited during a given sequence thus being stacked on a buffer layer deposited during a sequence preceding the given sequence.

4. Method according to any one of claims 1 to 2, wherein, before step d) of removing the masking layer (420), several times, preferably at least twice and preferably at least three times, a sequence of steps is carried out, each sequence comprising steps b1), b2) and c), and wherein a buffer layer deposited during a given sequence has a thickness greater than the thickness of a buffer layer deposited during a sequence preceding the given sequence.

5. Method according to the preceding claim, wherein said engraving step uses a tetramethyl ammonium hydroxide-based or hydrofluoric acid-based solution, preferably under an oxygen atmosphere.

6. Method according to any one of the preceding claims, wherein the stack comprises an inserted layer (610) arranged between the masking layer (420) and the layer to be engraved (410) and covering the layer to be engraved (410) during the implantation.

7. Method according to the preceding claim, wherein the masking layer (420) comprises carbon and wherein the thickness of the inserted layer (610) is sufficient for forming a preventative barrier, during the implantations (500a-500n), with carbon species coming from the masking layer (420) to enter inside the layer to be engraved (410).

8. Method according to any one of the two preceding claims, wherein the thickness of the inserted layer (610) is adjusted such that at least at the modified zones (411a, 411b, 411n), the ions are implanted continuously from the surface of the layer to be engraved (410).

9. Method according any one of claims 1 to 6, wherein the masking layer (420) is a resin or is a layer forming a hard mask, of which the material is preferably taken from among one or a combination of the following materials: carbon, SiOx, SiNy, SiARC and TiN.

10. Method according to any one of the preceding claims, where at least one of the implantations (500a-500n) is done with an implanter.

11. Method according to any one of claims 1 to 9, wherein at least one of the implantations (500a-500n) is done in a plasma reactor.

12. Method according to any one of the preceding claims, wherein steps b1) and b2) are selected, in particular the thickness of the buffer layer (430a-430n) and the implantation depth, such that the modified zones (411a, 411b, 411n) form a staircase profile.

13. Method according to the preceding claim, wherein after engraving a staircase profile in the layer to be engraved (410), a smoothing of said profile by oxidation and deoxidation of the material of the layer to be engraved (410) is proceeded with.

14. Method according to any one of the preceding claims, wherein the layer to be engraved (410) is a layer or a substrate of which the material is taken from among: silicon, silicon germanium, germanium, silicon nitride, sapphire, quartz, glass, SiOCH, porous SiOCH.

15. Method according to any one of the preceding claims, where said at least one buffer layer (430a-430n) is silicon nitride (SiN)-based, or silicon oxide (SiOₓ)-based, such as silicon dioxide (SiO₂).
